# FASCICULE DE BREVET EUROPEEN

(11) **EP 3 227 925 B1**
(45) Date de publication et mention de la délivrance du brevet: **27.02.2019**
(21) Numéro de dépôt: 15817437.5
(22) Date de dépôt: 01.12.2015
(51) Int. Cl.: H01L 31/0352, H01L 31/046

(54) **FIL TEXTILE PHOTOVOLTAÏQUE**
PHOTOVOLTAISCHER TEXTILFADEN
PHOTOVOLTAIC TEXTILE THREAD

(30) Priorité: 02.12.2014 FR 1402736
(43) Date de publication de la demande: 11.10.2017
(73) Titulaire: Commissariat à l'énergie atomique et aux énergies alternatives, 75015 Paris (FR); Sunpartner Technologies, 13090 Aix-en-Provence (FR)
(72) Inventeur: DUCROS, Eric, 75015 Paris (FR); PERRAUD, Simon, 75015 Paris (FR); REYNES, Mathias, 13090 Aix en Provence (FR)
(74) Mandataire: Nicolle, Olivier
(86) Numéro de dépôt international: PCT/FR2015/000217
(87) Numéro de publication internationale: WO 2016/087724

(56) Documents cités:
- FR-A1- 2 961 022
- US-A- 4 913 744
- US-A1- 2008 264 472
- US-A1- 2010 012 167

## Description

### Domaine technique de l'invention

La présente invention concerne une architecture de fil textile photovoltaïque, ainsi que son procédé de fabrication.

### Etat de la technique

Il est connu que les produits textiles photovoltaïques peuvent être utilisés pour alimenter en électricité des fonctions de proximité, notamment dans les domaines applicatifs tels que les équipements de protection solaire (alimentation électrique de l'enrouleur d'un store banne photovoltaïque), les serres agricoles (alimentation électrique de la motorisation de voiles d'ombrage photovoltaïques), ou encore les sports et loisirs (chargeur d'un téléphone portable sur un sac à dos photovoltaïque).

Une solution technique particulièrement avantageuse pour obtenir une surface textile photovoltaïque consiste à intégrer la fonction photovoltaïque à l'échelle du fil textile. Le principe est de fabriquer des fils textiles photovoltaïques par dépôt de couches minces (absorbeur et électrodes), puis d'utiliser ces fils photovoltaïques pour produire une nappe textile par tissage ou tricotage.

On connaît à travers le brevet US4913744 plusieurs architectures de fils photovoltaïques. Un fil photovoltaïque connu est constitué d'un empilement de couches disposées de manière concentrique autour d'une électrode centrale. Ces couches concentriques comprennent au moins une couche semi-conductrice (matériau absorbeur) et une couche métallique opaque (contre-électrode). Avantageusement, la contre-électrode n'occupe qu'une portion de la circonférence du fil photovoltaïque (c'est-à-dire la portion opposée à la portion illuminée par la lumière ambiante), afin de limiter les effets d'ombrage et de maximiser la puissance électrique générée par le fil photovoltaïque (voir figure 3 du document US4913744). De manière alternative, cette contre-électrode peut être constituée d'un fil métallique autour duquel est enroulé en spirale un fil photovoltaïque (voir figure 7 du document US4913744), ce qui constitue une structure guipée.

Cependant, dans l'art antérieur, le fil photovoltaïque n'est constitué que d'une seule cellule photovoltaïque couvrant pratiquement toute la longueur du fil. Une telle architecture pose deux problèmes majeurs.

Premièrement, cette architecture de fil photovoltaïque est très sensible aux défauts dans l'absorbeur. En effet, du fait des techniques de fabrication mises en oeuvre pour obtenir le fil photovoltaïque (typiquement, des dépôts de couches minces sur un substrat filaire), une certaine densité linéique de défauts dans l'absorbeur est inévitable (par exemple, 1 défaut tous les 10 cm). Or, dans l'industrie textile, la longueur du fil est typiquement de l'ordre de plusieurs kilomètres. On voit donc que le fil photovoltaïque va probablement contenir un certain nombre de défauts dans l'absorbeur. S'il s'agit de défauts entraînant un court-circuit, du type dit « pin hole », alors un seul défaut sur le fil photovoltaïque peut provoquer la défaillance de l'ensemble du fil. La manière classique de contourner ce problème dans le domaine des dispositifs photovoltaïques en couches minces conventionnels (sur substrats en verre plans) consiste à réaliser une interconnexion monolithique, c'est-à-dire une mise en série d'un certain nombre de cellules sur un même substrat. Cependant, le procédé d'interconnexion monolithique, qui requiert trois gravures distinctes P1, P2, P3 de l'empilement de couches minces par cellule photovoltaïque, est très complexe à maîtriser à l'échelle industrielle sur un substrat filaire.

Deuxièmement, cette architecture de fil photovoltaïque rend problématique la découpe à façon du fil photovoltaïque ou de la nappe textile fabriquée à partir de fils photovoltaïques. En effet, avec cette architecture, la découpe se fait nécessairement au niveau de la zone active de la cellule photovoltaïque. Les défauts créés lors de la découpe, notamment les défauts entraînant un court-circuit, peuvent provoquer la défaillance de l'ensemble du fil photovoltaïque. US 2010/012167 A1 divulgue un fil photovoltaïque ayant une seconde électrode segmentée.

### Objets de l'invention

La présente invention vise donc à remédier à ces inconvénients, en proposant une nouvelle architecture de fil photovoltaïque qui permette de l'intégrer plus aisément dans une nappe textile, et qui soit compatible avec les procédés industriels utilisés pour tisser ou tricoter lesdits fils textiles.

Le fil photovoltaïque objet de l'invention comprend au moins :
(a) une âme centrale qui assure la tenue mécanique dudit fil photovoltaïque et qui assure directement ou indirectement le rôle d'une première électrode ;
(b) une couche mince semi-conductrice déposée sur tout ou partie de l'âme centrale et qui joue le rôle d'absorbeur ;
(c) une couche mince conductrice et transparente déposée sur l'absorbeur et qui forme la seconde électrode.

Le fil photovoltaïque est caractérisé en ce que la seconde électrode est segmentée selon l'axe longitudinal du fil photovoltaïque, alors que la première électrode et l'absorbeur

Le fil photovoltaïque comprend en outre un fil annexe constitué d'un matériau isolant et d'une couche mince métallique déposée sur ledit matériau isolant, ladite couche mince métallique étant segmentée de sorte que les segments métalliques soient en contact électrique avec les segments de la seconde électrode dudit fil photovoltaïque.

La segmentation de la seconde électrode permet d'obtenir différentes cellules photovoltaïques sur le même fil photovoltaïque. Lesdites cellules photovoltaïques ont en commun la première électrode, mais possèdent chacune leur propre segment de seconde électrode isolé électriquement des autres segments. Etant donné que la résistivité de la couche mince d'absorbeur est élevée (notamment s'il s'agit d'un absorbeur en silicium amorphe hydrogéné), chaque cellule photovoltaïque est découplée des autres cellules photovoltaïques du fil photovoltaïque, ainsi que des zones inter-segments.

Cette segmentation de la seconde électrode selon l'axe du fil photovoltaïque permet de résoudre le problème de l'extrême sensibilité aux défauts dans l'absorbeur. En effet, un défaut présent dans l'absorbeur au niveau d'une cellule photovoltaïque donnée (par exemple, un défaut entraînant un court-circuit) n'affecte pas les autres cellules photovoltaïques du fil photovoltaïque, car la cellule photovoltaïque défectueuse est découplée des autres cellules photovoltaïques du fait de la forte résistivité de la couche mince d'absorbeur.

Cette segmentation de la seconde électrode selon l'axe du fil photovoltaïque permet également de résoudre le problème de la découpe à façon du fil photovoltaïque ou de la nappe textile. En effet, si la découpe est effectuée au niveau d'une cellule photovoltaïque donnée, alors les défauts créés dans l'absorbeur au niveau de cette cellule photovoltaïque du fait de la découpe n'affectent pas les autres cellules photovoltaïques du fil photovoltaïque, du fait de la forte résistivité de la couche mince d'absorbeur. Alternativement, si la découpe est effectuée au niveau d'une zone inter-segment, alors les défauts créés dans l'absorbeur au niveau de cette zone inter-segments suite à la découpe n'affectent aucune cellule photovoltaïque du fil photovoltaïque, du fait de la forte résistivité de la couche mince d'absorbeur.

Suivant différents modes de réalisation du dispositif, l'absorbeur est composé d'une couche mince de matériaux semi-conducteurs inorganiques ou organiques, cristallins ou amorphes, opaques ou semi-transparents. Il peut s'agir avantageusement de couches minces à base de silicium amorphe hydrogéné ou microcristallin, d'arséniure de gallium, de tellurure de cadmium, d'un alliage de cuivre-indium-gallium-sélénium, d'un alliage de cuivre-zinc-étain-sélénium ou encore de polymères. Il peut s'agir de simples jonctions de type p-i-n ou p-n, ou de jonctions multiples dont les matériaux absorbent préférentiellement une partie différente du spectre lumineux. Elles peuvent être conçues pour convertir la lumière visible et/ou la lumière ultra-violette et/ou la lumière infrarouge en électricité.

Selon une variante de réalisation, la couche mince conductrice et transparente peut être recouverte, au moins en partie, d'une couche mince métallique afin de diminuer les pertes ohmiques dans la seconde électrode du fil photovoltaïque. La couche mince métallique est également segmentée selon l'axe du fil photovoltaïque. De plus, afin de réduire les effets d'ombrage, la couche mince métallique peut n'occuper qu'une portion de la circonférence du fil photovoltaïque, c'est-à-dire la portion opposée à la portion illuminée.

Selon les modes de réalisation retenus, la section de l'âme centrale peut être polygonale, rectangulaire, circulaire, elliptique, ou de toute autre forme.

Suivant différents modes de réalisation, l'âme centrale peut être intégralement constituée d'un matériau conducteur assurant à la fois la tenue mécanique et le rôle de première électrode. Dans ce cas, il n'est pas nécessaire que l'âme centrale soit recouverte d'une couche mince conductrice puisque ladite âme centrale joue directement le rôle de la première électrode.

Alternativement, l'âme centrale peut être constituée d'un matériau isolant assurant la tenue mécanique du fil photovoltaïque et sur lequel est déposée, au moins en partie, une couche mince conductrice métallique formant alors une première électrode. Avantageusement, lorsque l'âme centrale est constituée d'un matériau isolant dont la section est polygonale, alors la couche mince conductrice n'occupe qu'une portion d'une des faces du prisme issu dudit polygone sans recouvrir les arêtes dudit prisme. Dans cette configuration, les défauts présents dans l'absorbeur au niveau des arêtes du prisme qui correspondent à des ruptures de pente, et donc à des zones de défauts dus à un dépôt non conforme des couches minces, n'affectent pas la cellule photovoltaïque du fait de la forte résistivité de la couche mince d'absorbeur.

Selon l'invention, les pertes ohmiques dans la seconde électrode du fil photovoltaïque sont diminuées en adjoignant à la couche mince conductrice et transparente un élément métallique présent sur un ou plusieurs fils annexes. Le fil photovoltaïque et les fils annexes peuvent par exemple être assemblés dans une structure stratifiée ou guipée. L'élément métallique présent sur le ou les fils annexes est segmenté, selon un axe parallèle à l'axe du fil photovoltaïque.

Un autre objet de l'invention est une nappe textile comportant une pluralité desdits fils photovoltaïques dans laquelle une cellule photovoltaïque donnée définie sur un fil photovoltaïque donné peut être adressée individuellement, par exemple en établissant un contact électrique entre un fil métallique et le segment de seconde électrode propre à cette cellule photovoltaïque. Les cellules photovoltaïques de plusieurs fils photovoltaïques sont interconnectées électriquement en parallèle pour former un module photovoltaïque.

Suivant un mode de réalisation particulier, les premières électrodes de chacun desdits fils photovoltaïques peuvent être connectées électriquement au moyen d'un fil d'interconnexion.

Suivant un autre mode de réalisation particulier, chaque segment de seconde électrode de chacun des fils photovoltaïques est relié via un fil de connexion à un interrupteur électronique qui pilote l'interconnexion de l'ensemble des segments de seconde électrode à un même fil.

Encore un autre objet de l'invention est un procédé de fabrication dudit fil photovoltaïque selon l'une quelconque des revendications 1 à 11, dans lequel procédé :
(a) on approvisionne une âme centrale en matériau conducteur, ou en matériau isolant revêtu d'une couche conductrice ;
(b) lorsque l'âme centrale est isolante, on dépose dessus une couche mince conductrice faisant office de première électrode;
(c) on dépose une couche mince d'absorbeur ;
(d) on masque certaines parties de l'absorbeur correspondant aux zones inter-segments ;
(e) on dépose à travers le masque une couche mince conductrice et transparente ;
(f) on ôte le masque mécaniquement ou par dissolution de matière.

Pour l'étape (d), il peut s'agir par exemple d'un procédé de sérigraphie ou de spray. L'étape (e) correspond typiquement à un procédé dit de « lift-off ».

Un procédé alternatif de fabrication dudit fil photovoltaïque selon l'une quelconque des revendications 1 à 11 consiste à :
(a) approvisionner une âme centrale en matériau conducteur ou en matériau isolant revêtu d'une couche conductrice;
(b) lorsque l'âme centrale est isolante, on dépose dessus une couche mince conductrice faisant office de première électrode ;
(c) déposer une couche mince d'absorbeur ;
(d) déposer une couche mince conductrice et transparente ;
(e) graver ladite couche mince conductrice et transparente par gravure chimique en voie humide, par laser ou par plasma.

Il est important de noter que la segmentation de la seconde électrode selon l'axe du fil photovoltaïque, en conservant une première électrode et un absorbeur continus, est un procédé beaucoup plus simple à mettre en oeuvre qu'une interconnexion monolithique classique, pour deux raisons principales. La première raison est que la segmentation de la seconde électrode ne requiert qu'une seule étape de structuration par cellule photovoltaïque, contre trois étapes de structuration par cellule photovoltaïque dans le cas de l'interconnexion monolithique classique (P1, P2, P3). La seconde raison vient du fait que la segmentation de la seconde électrode ne requiert qu'une résolution spatiale typiquement supérieure à 1 mm, contre une résolution spatiale inférieure à 100 µm dans le cas de l'interconnexion monolithique classique.

L'invention trouve ses principales applications dans les équipements de protection solaire, comme les bâches et les stores, les serres agricoles, les vêtements ou encore les matériels de sports et loisirs, comme les sacs à dos.

### Figures

L'invention sera mieux comprise à l'aide de sa description détaillée, en relation avec les figures, dans lesquelles :
- les figures 1a, 1b et 1c représentent schématiquement et respectivement, une vue en perspective, une vue en coupe longitudinale et une vue en coupe transversale du fil photovoltaïque avant dépôt de la seconde électrode ;
- les figures 2a, 2b, 2c et 2d représentent schématiquement et respectivement, une vue en perspective, une vue en coupe longitudinale et une vue en coupe transversale du fil photovoltaïque après dépôt de la seconde électrode, avant l'adjonction du fil annexe selon l'invention ;
- les figures 3a, 3b et 3c représentent schématiquement et respectivement, une vue en perspective, une vue en coupe longitudinale et une vue en coupe transversale du fil photovoltaïque après dépôt d'une couche mince métallique sur la seconde électrode, avant l'adjonction du fil annexe selon l'invention ;
- les figures 4a, 4b et 4c représentent schématiquement et respectivement, une vue en perspective, une vue en coupe longitudinale et une vue en coupe transversale de la structure d'un des fils photovoltaïques d'une nappe textile, avant l'adjonction du fil annexe selon l'invention ;
- la figure 5 est un schéma électrique d'un fil photovoltaïque selon l'invention et d'une partie de l'électronique de gestion de l'énergie ;
- les figures 6a, 6b et 6c représentent schématiquement et respectivement, une vue en perspective, une vue en coupe longitudinale et une vue en coupe transversale d'une variante de la structure d'un fil photovoltaïque, avant l'adjonction du fil annexe selon l'invention ;
- les figures 7a et 7b représentent schématiquement et respectivement une vue en perspective et une vue en coupe transversale du fil photovoltaïque auquel est adjoint le fil annexe selon l'invention ;
- la figure 8 représente schématiquement une vue en perspective du fil photovoltaïque auquel est adjoint le fil annexe segmenté avec une période spatiale plus faible que celle du fil photovoltaïque ;
- les figures 9a et 9b montrent schématiquement l'interconnexion de plusieurs fils photovoltaïques dans une nappe textile, associés à un système électronique de gestion de l'énergie.

Les figures ne sont pas à l'échelle, les épaisseurs relatives des composants du fil photovoltaïque étant volontairement exagérées pour mieux faire apparaître sa structure.

### Description détaillée

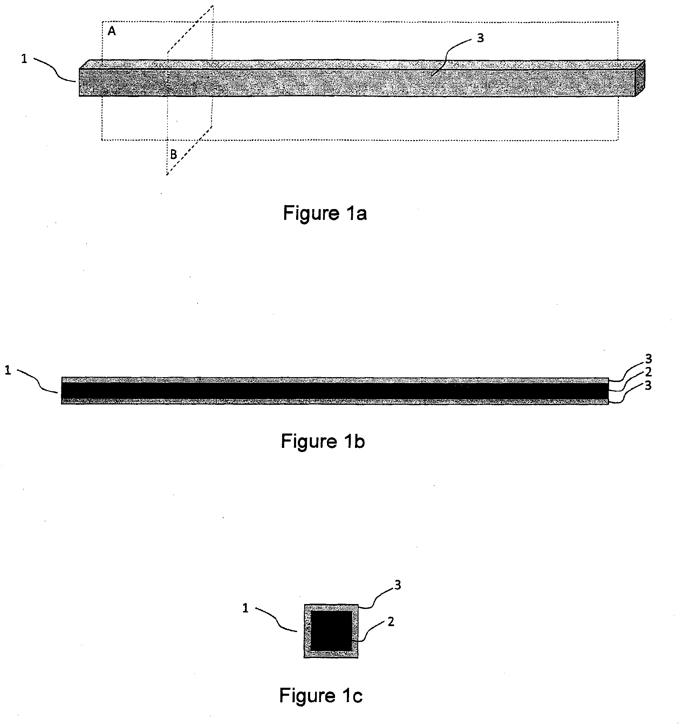

On se réfère aux figures 1a, 1b et 1c, qui représentent schématiquement une partie du fil photovoltaïque **1** avant dépôt de la seconde électrode. Ladite partie du fil photovoltaïque **1** est vue en perspective (figure 1a), en coupe longitudinale selon le plan **A** qui contient l'axe central dudit fil **1** (figure 1b), et en coupe transversale selon le plan **B** orthogonal à l'axe longitudinal dudit fil **1** (figure 1c). A ce stade du procédé de fabrication, le fil photovoltaïque **1** est constitué d'une âme centrale conductrice **2** et d'un absorbeur **3**. L'absorbeur **3** est une couche mince semi-conductrice déposée sur l'âme centrale **2**. L'âme centrale **2** peut être entièrement métallique, par exemple en argent ou en aluminium, et assure alors directement à la fois le rôle de support mécanique et de première électrode du fil photovoltaïque **1**. Alternativement, l'âme centrale peut comporter un matériau isolant pour assurer sa tenue mécanique, et être recouverte d'une couche mince métallique pour assurer indirectement le rôle de première électrode du fil photovoltaïque **1**. La section de l'âme centrale **2** peut être rectangulaire, comme représenté sur les figures 1a, 1b et 1c, mais également circulaire, elliptique, ou de toute autre forme. Les dimensions de la section de l'âme centrale **2** sont typiquement comprises entre 1 µm et 10 mm, et de préférence entre 10 µm et 5 mm. L'absorbeur **3** est préférentiellement une couche mince en silicium amorphe hydrogéné, d'épaisseur typiquement comprise entre 100 nm et 500 nm.

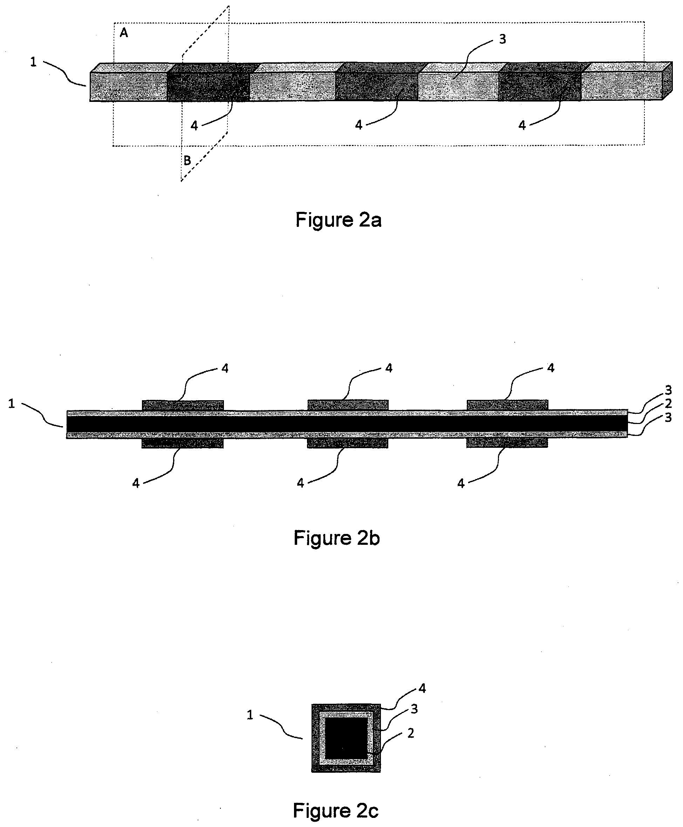

Les figures 2a, 2b et 2c représentent schématiquement le fil photovoltaïque **1** après dépôt de la seconde électrode **4**. Le fil photovoltaïque **1** est vu en perspective (figure 2a), en coupe longitudinale selon le plan **A** qui contient l'axe central dudit fil **1** (figure 2b), et en coupe transversale selon le plan **B** orthogonal à l'axe dudit fil **1** (figure 2c). A ce stade du procédé de fabrication, le fil photovoltaïque **1** comprend une seconde électrode **4** qui est une couche mince électriquement conductrice et transparente déposée sur l'absorbeur **3**. La seconde électrode **4** peut être une couche mince d'oxyde transparent conducteur, par exemple une couche mince d'oxyde d'indium dopé à l'étain, ou une couche mince d'oxyde de zinc dopé à l'aluminium, d'épaisseur typiquement comprise entre 100 nm et 1 µm.

Selon l'invention, la seconde électrode **4** est segmentée selon l'axe du fil photovoltaïque **1**, alors que la première électrode **2** et l'absorbeur **3** sont continus. La longueur des segments de seconde électrode **4** peut être comprise entre 1 mm et 1 m, de préférence entre 10 cm et 50 cm, et la longueur des zones inter-segments peut être comprise entre 10 µm et 10 cm, de préférence entre 1 mm et 1 cm. Cette segmentation de la seconde électrode **4** permet d'obtenir différentes cellules photovoltaïques sur le fil photovoltaïque **1**, lesdites cellules photovoltaïques ayant en commun la première électrode **2**, mais possédant chacune leur propre segment de seconde électrode **4** isolé électriquement des autres segments. Etant donné que la résistivité de la couche mince d'absorbeur **3** est élevée, notamment lorsqu'il s'agit d'un absorbeur en silicium amorphe hydrogéné, chaque cellule photovoltaïque est découplée des autres cellules photovoltaïques du fil photovoltaïque **1**, ainsi que des zones inter-segments. Ainsi, un défaut présent dans l'absorbeur au niveau d'une cellule photovoltaïque donnée (par exemple, un défaut entraînant un court-circuit) n'affecte pas les autres cellules photovoltaïques du fil photovoltaïque **1**, car la cellule photovoltaïque défectueuse est découplée des autres cellules photovoltaïques du fait de la forte résistivité de la couche mince d'absorbeur **3**.

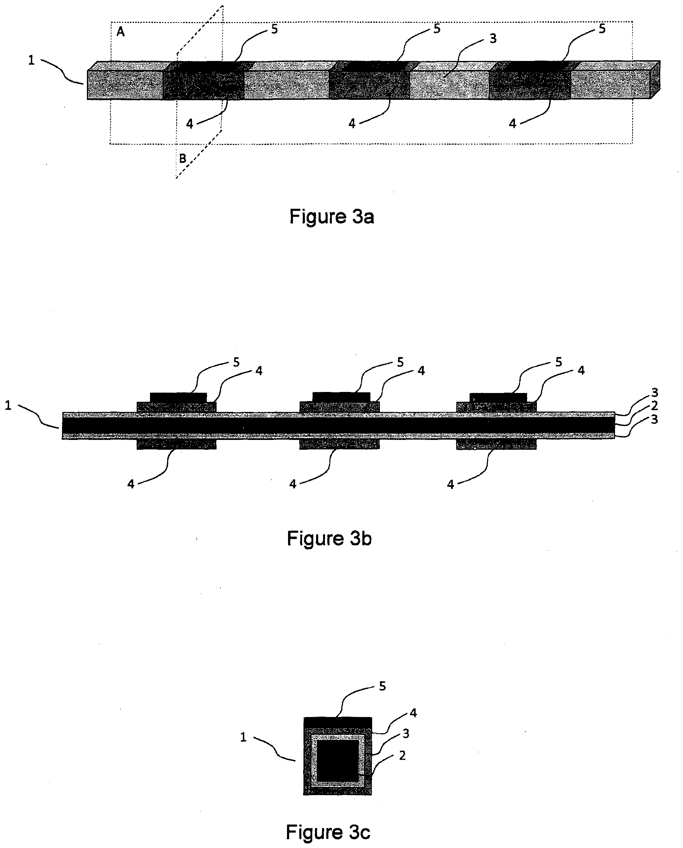

Les figures 3a, 3b et 3c représentent schématiquement le fil photovoltaïque **1** après dépôt d'une couche mince métallique **5** sur la couche mince conductrice et transparente **4**. Il s'agit d'une étape optionnelle, permettant de diminuer les pertes ohmiques dans la seconde électrode **4**. Le fil photovoltaïque **1** est vu en perspective (figure 3a), en coupe longitudinale selon le plan **A** qui contient l'axe central dudit fil **1** (figure 3b), et en coupe transversale selon le plan **B** orthogonal à l'axe dudit fil **1** (figure 3c). A ce stade du procédé de fabrication, le fil photovoltaïque comprend une couche mince métallique **5** déposée sur la couche mince conductrice et transparente **4**. La couche mince métallique **5** peut être une couche mince en argent ou en aluminium, d'épaisseur typiquement comprise entre 100 nm et 1 µm. La couche mince métallique **5** est segmentée selon l'axe longitudinal du fil photovoltaïque **1**, pour conserver les effets de la segmentation de la couche mince conductrice et transparente **4**. De plus, afin de réduire les effets d'ombrage, la couche mince métallique **5** peut n'occuper qu'une portion de la circonférence du fil photovoltaïque **1**, c'est-à-dire la portion opposée à la portion illuminée (comme représenté sur les figures 3a, 3b et 3c).

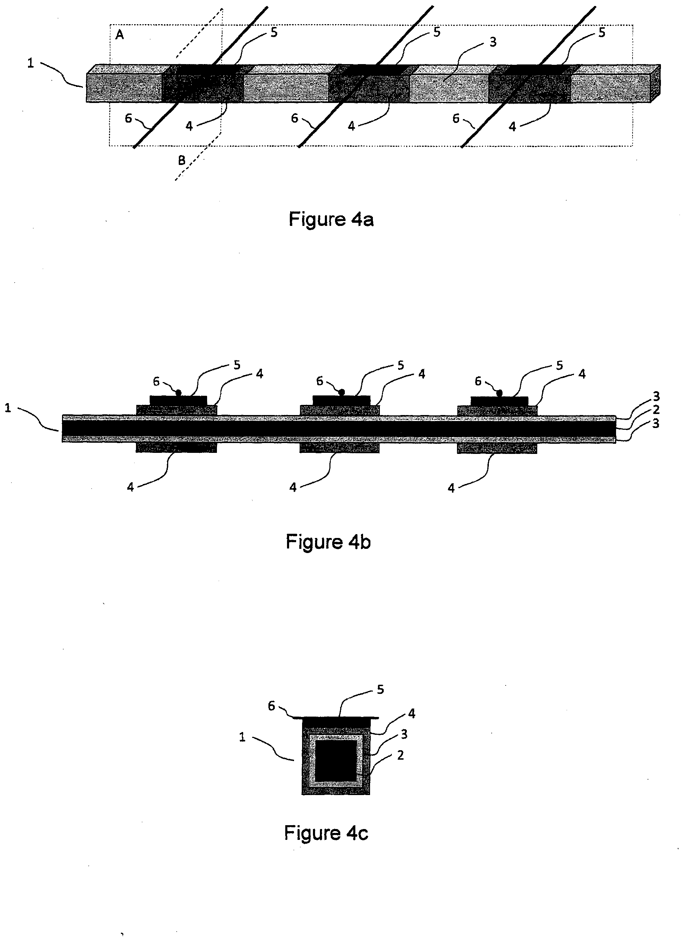

Les figures 4a, 4b et 4c représentent schématiquement un des fils photovoltaïques **1** d'une nappe textile. Le fil photovoltaïque **1** est vu en perspective (figure 4a), en coupe longitudinale selon le plan **A** qui contient l'axe central dudit fil **1** (figure 4b), et en coupe transversale selon le plan **B** orthogonal à l'axe dudit fil **1** (figure 4c). Dans la nappe textile, chaque cellule photovoltaïque définie sur le fil photovoltaïque **1** est adressée individuellement, en établissant un contact électrique entre un fil métallique **6** et le segment de couche mince métallique **5** propre à la cellule photovoltaïque. Ainsi, les segments métalliques sont en contact électrique avec les segments de la seconde électrode **4** du fil photovoltaïque.

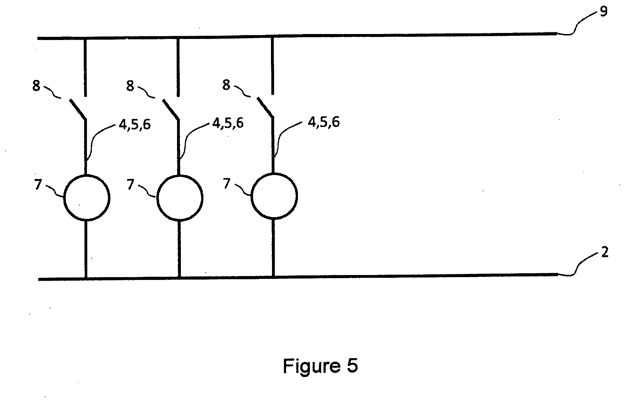

La figure 5 est un schéma électrique du fil photovoltaïque **1** dans la nappe textile et d'une partie de l'électronique de gestion de l'énergie. Les cellules photovoltaïques **7** définies sur le fil photovoltaïque **1** ont en commun la première électrode **2**, mais possèdent chacune leur propre segment de seconde électrode **4**, leur propre segment de couche métallique **5**, et leur propre fil métallique **6**.

Ainsi, chaque segment de seconde électrode **4** de chacun des fils photovoltaïques **1,11** est relié via un fil de connexion **6** à un interrupteur électronique **8** qui pilote l'interconnexion de l'ensemble des segments de seconde électrode **4** à un même fil **9**.

Une électronique de gestion adaptée permet de sélectionner les cellules photovoltaïques **7** fonctionnelles. Les cellules photovoltaïques **7** fonctionnelles sont interconnectées en parallèle, c'est-à-dire que leurs segments de seconde électrode **4** sont connectés à un même fil de connexion **9** grâce à la fermeture d'interrupteurs électroniques **8** tels que des transistors connectés à chacun des fils **6**. Les cellules photovoltaïques **7** en court-circuit, c'est-à-dire présentant une tension en circuit ouvert inférieure à un certain seuil, sont exclues grâce à l'ouverture d'interrupteurs électroniques **8** tels que des transistors.

Alternativement, l'électronique de gestion est remplacée par des fusibles en contact avec les fils **6** reliant chacune des cellules photovoltaïques **7** au fil **9**. Ainsi, chaque segment de seconde électrode **4** de chacun des fils photovoltaïques **1,11** est en contact électrique avec un fusible.

Ceux-ci permettent d'isoler les cellules en court-circuit. En effet, l'augmentation de l'intensité du courant électrique traversant une cellule photovoltaïque en court-circuit fait fondre le fusible et déconnecte donc la cellule concernée du circuit électrique. Par exemple, ces fusibles peuvent être réalisés par le dépôt d'une couche mince sur les segments de seconde électrode **4**.

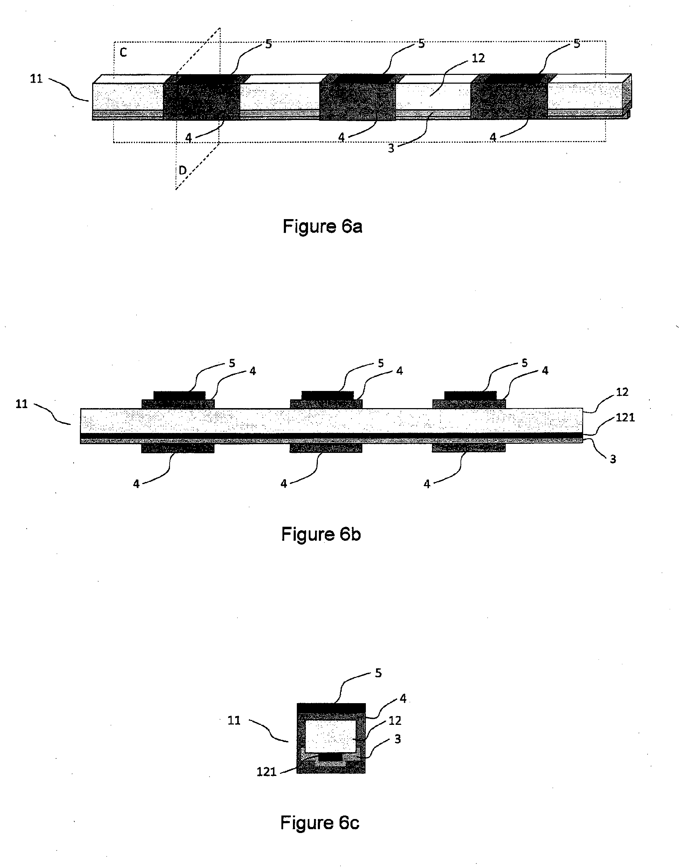

Les figures 6a, 6b et 6c représentent schématiquement un fil photovoltaïque **11**. Le fil photovoltaïque **11** est vu en perspective (figure 6a), en coupe longitudinale selon le plan **C** qui contient l'axe central dudit fil **11** (figure 6b), et en coupe transversale selon le plan **D** orthogonal à l'axe dudit fil **11** (figure 6c). A la différence du fil photovoltaïque **1** représenté à la figure 3a, l'âme centrale du fil photovoltaïque **11** est constituée d'un matériau isolant **12** (par exemple un ruban en polymère) sur lequel est déposée une couche mince métallique **121** qui joue le rôle de la première électrode du fil photovoltaïque **11**. La couche mince métallique **121** peut être une couche mince en argent ou en aluminium. L'âme **12** est de section rectangulaire. La couche mince métallique **121** n'occupe qu'une zone s'inscrivant dans un seul des côtés du rectangle et excluant les sommets du rectangle. Dans cette configuration, les défauts présents dans l'absorbeur **3** au niveau des sommets du rectangle (les sommets correspondent à des ruptures de pente, et donc à des zones de défauts dus à un dépôt non conforme des couches minces) n'affectent pas la cellule photovoltaïque, du fait de la forte résistivité de la couche mince d'absorbeur **3**.

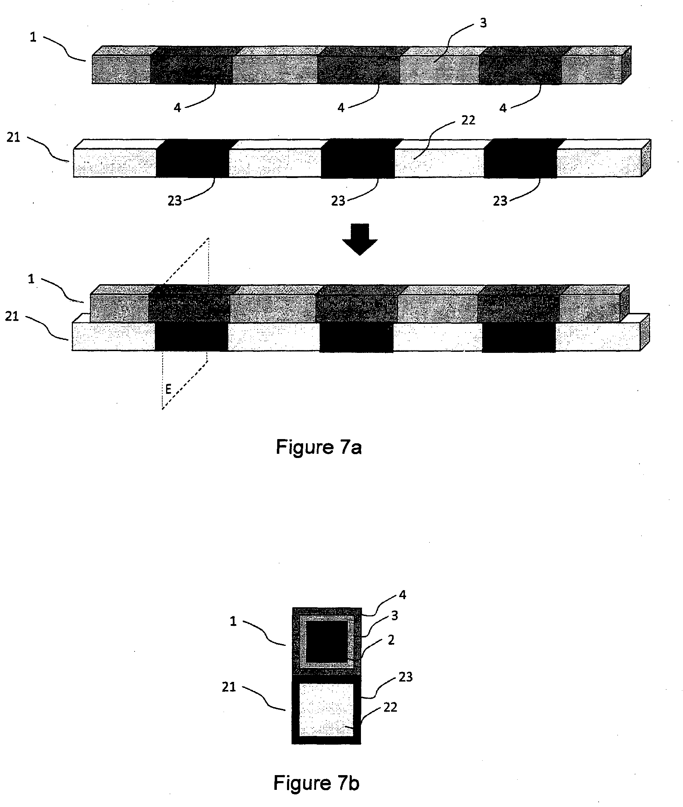

Les figures 7a (vue en perspective) et 7b (vue en coupe transversale selon le plan **E**) représentent schématiquement le fil photovoltaïque **1** auquel est adjoint un fil annexe **21** selon la présente invention, afin de diminuer les pertes ohmiques dans la seconde électrode **4**. Le fil annexe **21** est constitué d'un matériau électriquement isolant **22** et d'une couche mince métallique **23** déposée sur ledit matériau isolant **22**. Le fil photovoltaïque **1** et le fil annexe **21** sont assemblés dans une structure stratifiée (le fil annexe **21** est contrecollé sur le fil photovoltaïque **1**). La couche mince métallique **23** est segmentée dans le sens longitudinal, pour conserver les effets de la segmentation de la couche mince conductrice et transparente **4**. Le fil annexe **21** peut également remplir une fonction mécanique, en limitant les contraintes exercées sur le fil photovoltaïque **1**. Pour cela, le fil photovoltaïque **1** peut être plus court que le fil annexe **21**, comme représenté à la figure 7a.

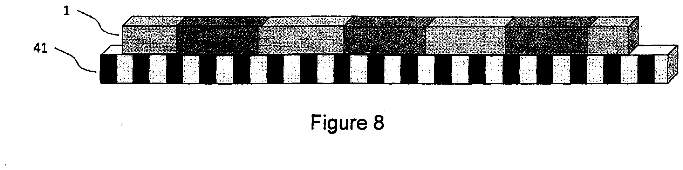

Si le fil annexe **41** est segmenté avec une période spatiale plus faible que celle du fil photovoltaïque **11** (voir figure 8), c'est-à-dire que la période spatiale des segments métalliques (23) est plus faible que la période spatiale des segments de la seconde électrode (4), alors un alignement du fil annexe par rapport au fil photovoltaïque n'est pas nécessaire. Ceci est particulièrement avantageux dans le cas d'une structure guipée (non représentée), où un alignement est difficile à effectuer.

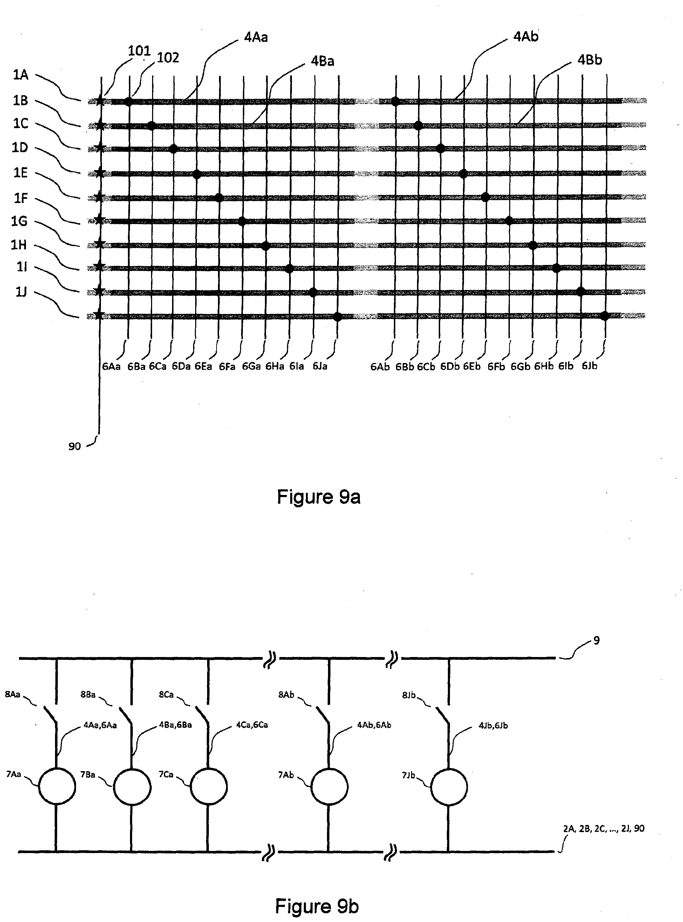

La figure 9a représente schématiquement plusieurs fils photovoltaïques (**1A**, **1B**,..., **1J**) dans une nappe textile. Dans l'exemple présenté à la figure 9a, chaque fil photovoltaïque est composé de deux cellules photovoltaïques (deux segments **4Aa** et **4Ab** de seconde électrode sur le fil photovoltaïque **1A**, deux segments **4Ba** et **4Bb** de seconde électrode sur le fil photovoltaïque **1B**, ...). Chaque cellule photovoltaïque est adressée individuellement, en établissant un contact électrique **102** entre un fil métallique (**6Aa**, **6Ba**, ..., **6Jb**) et le segment (**4Aa**, **4Ba**, ..., **4Jb**) de seconde électrode correspondant. Un contact électrique **101** est établi entre un fil métallique **90** et la première électrode (**2A**, **2B**, ..., **2J**) de chaque fil photovoltaïque.

La figure 9b est le schéma électrique correspondant à la figure 9a, sur lequel les cellules photovoltaïques (**7Aa**, **7Ba**, ..., **7Jb**) sont interconnectées en parallèle à l'aide du fil 9 et pilotées de manière indépendante grâce à l'ouverture ou à la fermeture d'interrupteurs électroniques (**8Aa**, **8Ba**, ..., **8Jb**) tels que des transistors.

Alternativement, un seul et même fil métallique **6a** est en contact électrique avec les segments de seconde électrode (**4Aa**, **4Ba**, .... **4Ja**), alors qu'un autre fil métallique **6b** est en contact électrique avec les segments de seconde électrode (**4Ab**, **4Bb**, ..., **4Jb**). Le nombre de fils métalliques est ainsi réduit de façon considérable. Les cellules photovoltaïques (**7Aa**, **7Ba**, ..., **7Jb**) peuvent alors être adressées individuellement par des fusibles (non représentés), comme décrit dans le dernier paragraphe correspondant à la figure 5.

### Avantages de l'invention

Il résulte de ce qui précède que l'invention atteint les buts fixés. Elle décrit un fil photovoltaïque comportant une âme centrale, une couche mince d'absorbeur et une électrode transparente segmentée selon l'axe du fil photovoltaïque. En outre, il est prévu un fil annexe constitué d'un matériau isolant et d'une couche mince métallique déposée sur ledit matériau isolant, ladite couche mince métallique étant segmentée de sorte que les segments métalliques soient en contact électrique avec les segments de la seconde électrode dudit fil photovoltaïque. Par rapport à l'état de l'art, le fil photovoltaïque objet de l'invention a l'avantage de résoudre le problème de l'extrême sensibilité aux défauts dans l'absorbeur. Il permet en outre de résoudre le problème de la découpe à façon du fil photovoltaïque ou de la nappe textile.

**Liste des repères utilisés sur les figures :**

| | | | |
|---|---|---|---|
| 1 | Fil photovoltaïque | 11 | Fil photovoltaïque |
| 2 | Ame centrale conductrice | 12 | Ame centrale isolante |
| 3 | Absorbeur | 21 | Fil annexe |
| 4 | Seconde électrode | 22 | Matériau isolant |
| 5 | Couche mince métallique | 23 | Couche mince métallique |
| 6 | Fil métallique | 41 | Fil annexe segmenté |
| 7 | Cellule photovoltaïque | 90 | Fil d'interconnexion |
| 8 | Interrupteur électronique | 102 | Contact électrique |
| 9 | Fil de connexion | 121 | Couche mince métallique |

## Revendications

1. Fil photovoltaïque (1,11) comportant au moins :
(a) une âme centrale (2,12) qui assure la tenue mécanique dudit fil photovoltaïque et qui assure directement ou indirectement le rôle d'une première électrode ;
(b) une couche mince semi-conductrice (3) déposée sur l'âme centrale (2,12), et qui joue le rôle d'absorbeur ;
(c) une couche mince conductrice et transparente (4) déposée sur l'absorbeur (3) et qui forme la seconde électrode (4) ;
ladite seconde électrode (4) étant segmentée selon l'axe longitudinal du fil photovoltaïque, **caractérisé en ce que** la première électrode (2,12) et l'absorbeur (3) sont continus, et **en ce qu'**il comprend en outre un fil annexe (21) constitué d'un matériau isolant (22) et d'une couche mince métallique (23) déposée sur ledit matériau isolant (22), ladite couche mince métallique (23) étant segmentée de sorte que les segments métalliques soient en contact électrique avec les segments de la seconde électrode (4) dudit fil photovoltaïque

2. Fil photovoltaïque (1,11) selon la revendication 1, **caractérisé en ce que** l'âme centrale (2,12) est soit intégralement composée d'un matériau électriquement conducteur (2) assurant à la fois la tenue mécanique et le rôle de première électrode, soit composée d'un matériau électriquement isolant (12) assurant la tenue mécanique du fil photovoltaïque et d'une couche mince métallique (121) disposée sur ledit matériau isolant (12) et formant une première électrode.

3. Fil photovoltaïque (1,11) selon l'une quelconque des revendications précédentes, **caractérisé en ce que** la seconde électrode (4) ait des segments d'une longueur comprise entre 1 mm et 1 m, et des zones inter-segments d'une longueur comprise entre 10 µm et 10 cm.

4. Fil photovoltaïque (1,11) selon l'une quelconque des revendications précédentes, **caractérisé en ce que** la section de l'âme centrale (2,12) est soit polygonale, rectangulaire, circulaire, ou elliptique.

5. Fil photovoltaïque (1,11) selon l'une quelconque des revendications précédentes, **caractérisé en ce que** la section de l'âme centrale (2,12) a des dimensions comprises entre 1 µm et 10 mm.

6. Fil photovoltaïque (1,11) selon l'une quelconque des revendications 1 à 5, **caractérisé en ce que** l'âme centrale (2) est métallique, notamment en argent ou en aluminium.

7. Fil photovoltaïque (1,11) selon l'une quelconque des revendications précédentes, **caractérisé en ce que** l'absorbeur (3) est constitué de matériaux semi-conducteurs inorganiques ou organiques, cristallins ou amorphes, opaques ou semi-transparents.

8. Fil photovoltaïque (1,11) selon l'une quelconque des revendications précédentes, **caractérisé en ce que** la couche d'absorbeur (3) a une épaisseur comprise entre 100 nm et 500 nm.

9. Fil photovoltaïque (1,11) selon l'une quelconque des revendications précédentes, **caractérisé en ce que** la seconde électrode (4) est constituée d'une couche mince d'oxyde transparent conducteur, par exemple une couche mince d'oxyde d'indium dopé à l'étain, ou une couche mince d'oxyde de zinc dopé à l'aluminium, et d'épaisseur comprise entre 100 nm et 1 µm.

10. Fil photovoltaïque (1,11) selon l'une quelconque des revendications précédentes, **caractérisé en ce que** la seconde électrode (4) est recouverte, d'une couche mince métallique (5), notamment en argent ou en aluminium, et d'épaisseur comprise entre 100 nm et 1 µm.

11. Fil photovoltaïque (1,11) selon l'une quelconque desrevendications précédentes, **caractérisé en ce que** la période spatiale des segments métalliques (23) est plus faible que la période spatiale des segments de la seconde électrode (4).

12. Nappe textile constituée d'une pluralité de fils photovoltaïques (1,11) selon l'une quelconque des revendications précédentes, **caractérisée en ce que** les premières électrodes (2) de chacun desdits fils photovoltaïques (1,11) sont connectées électriquement au moyen d'un fil d'interconnexion (90).

13. Nappe textile constituée d'une pluralité de fils photovoltaïques (1,11) selon l'une quelconque des revendications 1 à 11, **caractérisée en ce que** chaque segment de seconde électrode (4) de chacun des fils photovoltaïques (1,11) est relié via un fil de connexion (6) à un interrupteur électronique (8) qui pilote l'interconnexion de l'ensemble des segments de seconde électrode (4) à un même fil (9).

14. Nappe textile constituée d'une pluralité de fils photovoltaïques (1,11) selon l'une quelconque des revendications 1 à 11, **caractérisée en ce que** chaque segment de seconde électrode (4) de chacun des fils photovoltaïques (1,11) est en contact électrique avec un fusible.

15. Procédé de fabrication du fil photovoltaïque (1,11) selon l'une quelconque des revendications 1 à 11, **caractérisé en ce qu'**il comporte successivement des étapes consistant à :
(a) approvisionner une âme centrale (2) en matériau conducteur formant une première électrode, ou une âme centrale (12) en matériau isolant revêtue d'une couche mince métallique (121) formant une première électrode;
(b) déposer une couche mince d'absorbeur (3) sur l'âme centrale (2,12) ;
(c) masquer certaines parties de l'absorbeur (3) correspondant aux zones inter-segments ;
(d) déposer à travers le masque une couche mince conductrice et transparente (4) ;
(e) ôter le masque mécaniquement ou par dissolution de matière.

16. Procédé de fabrication du fil photovoltaïque (1,11) selon l'une quelconque des revendications 1 à 11, **caractérisé en ce qu'**il comporte successivement des étapes consistant à :
(a) approvisionner une âme centrale (2,12) en matériau conducteur formant une première électrode, ou une âme centrale (12) en matériau isolant revêtue d'une couche mince métallique (121) formant une première électrode ;
(b) déposer une couche mince d'absorbeur (3) sur l'âme centrale (2,12) ;
(c) déposer une couche mince conductrice et transparente (4) ;
(d) graver ladite couche mince conductrice et transparente (4) par gravure chimique en voie humide, par laser ou par plasma.

17. Equipements de protection solaire, serres agricoles, vêtements ou matériels de sports et loisirs, **caractérisés en ce qu'**ils comprennent une pluralité de fils photovoltaïques (1) selon l'une quelconque des revendications 1 à 11.

## Patentansprüche

1. Photovoltaischer Draht (1, 11), umfassend mindestens:
(a) einen zentralen Kern (2, 12), der die mechanische Beständigkeit des photovoltaischen Drahts sicherstellt und der direkt oder indirekt die Funktion einer ersten Elektrode erfüllt;
(b) eine dünne Halbleiterschicht (3), die auf dem zentralen Kern (2, 12) abgeschieden ist und die die Funktion eines Absorbers erfüllt;
(c) eine dünne leitfähige und transparente Schicht (4), die auf dem Absorber (3) abgeschieden ist und die die zweite Elektrode (4) bildet;
wobei die zweite Elektrode (4) entlang der Längsachse des photovoltaischen Drahts segmentiert ist,
**dadurch gekennzeichnet, dass** die erste Elektrode (2, 12) und der Absorber (3) durchgehend sind, und
dass er unter anderem einen Nebendraht (21) umfasst, der aus einem isolierenden Material (22) und aus einer dünnen metallischen Schicht (23), die auf dem isolierenden Material (22) abgeschieden ist, besteht, wobei die dünne metallische Schicht (23) derart segmentiert ist, dass die metallischen Segmente in elektrischem Kontakt mit den Segmenten der zweiten Elektrode (4) des photovoltaischen Drahts sind.

2. Photovoltaischer Draht (1, 11) nach Anspruch 1, **dadurch gekennzeichnet, dass** der zentrale Kern (2, 12) entweder vollständig aus einem elektrisch leitfähigen Material (2) besteht, das gleichzeitig die mechanische Beständigkeit und die Funktion als erste Elektrode sicherstellt, oder aus einem elektrisch isolierenden Material (12), das die mechanische Beständigkeit des photovoltaischen Drahts sicherstellt, und einer dünnen metallischen Schicht (121), die auf dem isolierenden Material (12) angeordnet ist und eine erste Elektrode bildet, besteht.

3. Photovoltaischer Draht (1, 11) nach einem der vorhergehenden Ansprüche, **dadurch gekennzeichnet, dass** die zweite Elektrode (4) Segmente mit einer Länge zwischen 1 mm und 1 m und Zwischensegmentbereiche mit einer Länge zwischen 10 µm und 10 cm aufweist.

4. Photovoltaischer Draht (1, 11) nach einem der vorhergehenden Ansprüche, **dadurch gekennzeichnet, dass** der Querschnitt des zentralen Kerns (2, 12) entweder vieleckig, rechteckig, rund oder elliptisch ist.

5. Photovoltaischer Draht (1, 11) nach einem der vorhergehenden Ansprüche, **dadurch gekennzeichnet, dass** der Querschnitt des zentralen Kerns (2, 12) Abmessungen zwischen 1 µm und 10 mm aufweist.

6. Photovoltaischer Draht (1, 11) nach einem der Ansprüche 1 bis 5, **dadurch gekennzeichnet, dass** der zentrale Kern (2) metallisch ist, insbesondere aus Silber oder aus Aluminium.

7. Photovoltaischer Draht (1, 11) nach einem der vorhergehenden Ansprüche, **dadurch gekennzeichnet, dass** der Absorber (3) aus anorganischen oder organischen, kristallinen oder amorphen, opaken oder halbtransparenten Halbleitermaterialien besteht.

8. Photovoltaischer Draht (1, 11) nach einem der vorhergehenden Ansprüche, **dadurch gekennzeichnet, dass** die Absorberschicht (3) eine Dicke zwischen 100 nm und 500 nm aufweist.

9. Photovoltaischer Draht (1, 11) nach einem der vorhergehenden Ansprüche, **dadurch gekennzeichnet, dass** die zweite Elektrode (4) aus einer dünnen transparenten leitfähigen Oxidschicht, beispielsweise einer dünnen zinndotierten Indiumoxidschicht oder eine dünnen aluminiumdotierten Zinkoxidschicht, mit einer Dicke zwischen 100 nm und 1 µm besteht.

10. Photovoltaischer Draht (1, 11) nach einem der vorhergehenden Ansprüche, **dadurch gekennzeichnet, dass** die zweite Elektrode (4) (5) von einer dünnen metallischen Schicht, insbesondere aus Silber oder aus Aluminium, mit einer Dicke zwischen 100 nm und 1 µm bedeckt ist.

11. Photovoltaischer Draht (1, 11) nach einem der vorhergehenden Ansprüche, **dadurch gekennzeichnet, dass** die räumliche Periode der metallischen Segmente (23) kleiner ist als die räumliche Periode der Segmente der zweiten Elektrode (4).

12. Textile Matte, die aus einer Vielzahl von photovoltaischen Drähten (1, 11) nach einem der vorhergehenden Ansprüche besteht, **dadurch gekennzeichnet, dass** die ersten Elektroden (2) jedes der photovoltaischen Drähte (1, 11) mittels eines Verbindungsdrahts (90) elektrisch verbunden sind.

13. Textile Matte, die aus einer Vielzahl von photovoltaischen Drähten (1, 11) nach einem der Ansprüche 1 bis 11 besteht, **dadurch gekennzeichnet, dass** jedes Segment der zweiten Elektrode (4) jedes der photovoltaischen Drähte (1, 11) über einen Anschlussdraht (6) an einen elektronischen Schalter (8) angeschlossen ist, der die Verbindung des Satzes von Segmenten der zweiten Elektrode (4) mit demselben Draht (9) steuert.

14. Textile Matte, die aus einer Vielzahl von photovoltaischen Drähten (1, 11) nach einem der Ansprüche 1 bis 11 besteht, **dadurch gekennzeichnet, dass** jedes Segment der zweiten Elektrode (4) jedes der photovoltaischen Drähte (1, 11) in elektrischem Kontakt mit einer Schmelzsicherung ist.

15. Herstellungsverfahren des photovoltaischen Drahts (1, 11) nach einem der Ansprüche 1 bis 11, **dadurch gekennzeichnet, dass** es nacheinander die in Folgendem bestehenden Schritte umfasst:
(a) Bereitstellen eines zentralen Kerns (2) aus leitfähigem Material, der eine erste Elektrode bildet, oder eines zentralen Kerns (12) aus isolierendem Material, das mit einer dünnen metallischen Schicht (121) überzogen ist, der eine erste Elektrode bildet;
(b) Abscheiden einer dünnen Absorberschicht (3) auf dem zentralen Kern (2, 12);
(c) Abdecken bestimmter Abschnitte des Absorbers (3), die den Zwischensegmentbereichen entsprechen;
(d) Abscheiden einer dünnen leitfähigen und transparente Schicht (4) über der Abdeckung;
(e) Entfernen der Abdeckung auf mechanische Weise oder durch Materialauflösung.

16. Herstellungsverfahren des photovoltaischen Drahts (1, 11) nach einem der Ansprüche 1 bis 11, **dadurch gekennzeichnet, dass** es nacheinander die in Folgendem bestehenden Schritte umfasst:
(a) Bereitstellen eines zentralen Kerns (2, 12) aus leitfähigem Material, der eine erste Elektrode bildet, oder eines zentralen Kerns (12) aus isolierendem Material, das mit einer dünnen metallischen Schicht (121) überzogen ist, der eine erste Elektrode bildet;
(b) Abscheiden einer dünnen Absorberschicht (3) auf dem zentralen Kern (2, 12);
(c) Abscheiden einer dünnen leitfähigen und transparente Schicht (4);
(d) Ätzen der dünnen leitfähigen und transparenten Schicht (4) durch chemische Nassätzung, durch Laserätzung oder durch Plasmaätzung.

17. Sonnenschutzausrüstungen, landwirtschaftliche Gewächshäuser, Sport- und Freizeitkleidungsstücke oder -materialien, **dadurch gekennzeichnet, dass** sie eine Vielzahl von photovoltaischen Drähten (1) nach einem der Ansprüche 1 bis 11 umfassen.

## Claims

1. Photovoltaic yarn (1, 11) comprising at least:
(a) a central core (2, 12) which provides the mechanical strength of said photovoltaic yarn and which directly or indirectly acts as a first electrode;
(b) a semiconductor thin film (3) deposited on the central core (2, 12), and which acts as absorber;
(c) a conductive and transparent thin film (4) deposited on the absorber (3) and which forms the second electrode (4);
said second electrode (4) being segmented along the longitudinal axis of the photovoltaic thread, **characterized in that** the first electrode (2, 12) and the absorber (3) are continuous, and **in that** it further comprises an additional yarn (21) consisting of an insulating material (22) and of a metallic thin film (23) deposited on said insulating material (22), said metallic thin film (23) being segmented so that the metallic segments are in electrical contact with the segments of the second electrode (4) of said photovoltaic yarn.

2. Photovoltaic yarn (1, 11) according to Claim 1, **characterized in that** the central core (2, 12) is either entirely composed of an electrically conductive material (2) simultaneously providing the mechanical strength and acting as the first electrode, or is composed of an electrically insulating material (12) that provides the mechanical strength of the photovoltaic yarn and of a metallic thin film (121) positioned on said insulating material (12) and forming a first electrode.

3. Photovoltaic yarn (1, 11) according to either one of the preceding claims, **characterized in that** the second electrode (4) has segments having a length of between 1 mm and 1 m, and inter-segment zones having a length of between 10 µm and 10 cm.

4. Photovoltaic yarn (1, 11) according to any one of the preceding claims, **characterized in that** the cross section of the central core (2, 12) is either polygonal, rectangular, circular or elliptical.

5. Photovoltaic yarn (1, 11) according to any one of the preceding claims, **characterized in that** the cross section of the central core (2, 12) has dimensions of between 1 µm and 10 mm.

6. Photovoltaic yarn (1, 11) according to any one of Claims 1 to 5, **characterized in that** the central core (2) is metallic, in particular made of silver or of aluminium.

7. Photovoltaic yarn (1, 11) according to any one of the preceding claims, **characterized in that** the absorber (3) consists of inorganic or organic, crystalline or amorphous, opaque or semitransparent semiconductor materials.

8. Photovoltaic yarn (1, 11) according to any one of the preceding claims, **characterized in that** the layer of absorber (3) has a thickness of between 100 nm and 500 nm.

9. Photovoltaic yarn (1, 11) according to any one of the preceding claims, **characterized in that** the second electrode (4) consists of a thin film of transparent conductive oxide, for example a thin film of tin-doped indium oxide, or a thin film of aluminium-doped zinc oxide, and with a thickness of between 100 nm and 1 µm.

10. Photovoltaic yarn (1, 11) according to any one of the preceding claims, **characterized in that** the second electrode (4) is covered with a metallic thin film (5), in particular made of silver or of aluminium, and with a thickness of between 100 nm and 1 µm.

11. Photovoltaic yarn (1, 11) according to any one of the preceding claims, **characterized in that** the spatial period of the metallic segments (23) is smaller than the spatial period of the segments of the second electrode (4).

12. Textile sheet consisting of a plurality of photovoltaic yarns (1, 11) according to any one of the preceding claims, **characterized in that** the first electrodes (2) of each of said photovoltaic yarns (1, 11) are electrically connected by means of an interconnection wire (90).

13. Textile sheet consisting of a plurality of photovoltaic yarns (1, 11) according to any one of Claims 1 to 11, **characterized in that** each segment of the second electrode (4) of each of the photovoltaic yarns (1, 11) is connected via a connection wire (6) to an electronic switch (8) which controls the interconnection of all of the segments of the second electrode (4) to a same wire (9).

14. Textile sheet consisting of a plurality of photovoltaic yarns (1, 11) according to any one of Claims 1 to 11, **characterized in that** each segment of the second electrode (4) of each of the photovoltaic yarns (1, 11) is in electrical contact with a fuse.

15. Process for manufacturing the photovoltaic yarn (1, 11) according to any one of Claims 1 to 11, **characterized in that** it successfully comprises the steps consisting in:
(a) providing a central core (2) made of conductive material forming a first electrode, or a central core (12) made of insulating material coated with a metallic thin film (121) forming a first electrode;
(b) depositing a thin film of absorber (3) on the central core (2, 12);
(c) masking certain parts of the absorber (3) corresponding to the inter-segment zones;
(d) depositing across the mask a conductive and transparent thin film (4);
(e) removing the mask mechanically or by dissolving of material.

16. Process for manufacturing the photovoltaic yarn (1, 11) according to any one of Claims 1 to 11, **characterized in that** it successfully comprises the steps consisting in:
(a) providing a central core (2,12) made of conductive material forming a first electrode, or a central core (12) made of insulating material coated with a metallic thin film (121) forming a first electrode;
(b) depositing a thin film of absorber (3) on the central core (2, 12);
(c) depositing a conductive and transparent thin film (4);
(d) etching said conductive and transparent thin film (4) by wet chemical etching, by laser or by plasma.

17. Equipment for solar protection, agricultural greenhouses, sports and leisure clothing or equipment, **characterized in that** they comprise a plurality of photovoltaic yarns (1) according to any one of Claims 1 to 11.
